# EUROPÄISCHE PATENTSCHRIFT

(11) **EP 2 347 639 B1**
(45) Veröffentlichungstag und Bekanntmachung des Hinweises auf die Patenterteilung: **27.02.2013**
(21) Anmeldenummer: 09751846.8
(22) Anmeldetag: 26.10.2009
(51) Int. Cl.: H05K 1/14, H05K 3/36

(54) **BELEUCHTUNGSVORRICHTUNG MIT ZWEI LEITERPLATTEN**
ILLUMINATION DEVICE COMPRISING TWO PRINTED CIRCUIT BOARDS
DISPOSITIF D'ÉCLAIRAGE AVEC DEUX CARTES DE CIRCUITS

(30) Priorität: 12.11.2008 DE 102008056923
(43) Veröffentlichungstag der Anmeldung: 27.07.2011
(73) Patentinhaber: OSRAM GmbH, 81543 München (DE)
(72) Erfinder: PREUSCHL, Thomas, 93161 Sinzing (DE)
(86) Internationale Anmeldenummer: PCT/EP2009/064066
(87) Internationale Veröffentlichungsnummer: WO 2010/054924

(56) Entgegenhaltungen:
- DE-A1-102007 037 839
- JP-A- 2006 100 052
- US-A- 4 054 939
- US-A1- 2008 013 334
- US-B1- 6 305 949

## Beschreibung

### Technisches Gebiet

Die Erfindung betrifft eine Beleuchtungsvorrichtung umfassend mindestens eine Lichtquelle, insbesondere mindestens eine Leuchtdiode (LED), sowie mindestens zwei zumindest teilweise übereinander und bevorzugt annähernd parallel angeordnete Leiterplatten. Die Erfindung betrifft ebenfalls ein Verfahren zur Herstellung einer derartigen Beleuchtungsvorrichtung.

### Stand der Technik

Beleuchtungsvorrichtungen, insbesondere solche mit mindestens einer Leuchtdiode (LED), umfassen häufig mehrere Leiterplatten, auf denen zum Betrieb der Beleuchtungsvorrichtung erforderliche elektronische Bauelemente angeordnet sind. Bei mit LED ausgestatteten Beleuchtungsvorrichtungen sind darauf häufig auch die Leuchtdioden selbst angeordnet.

Da LED wie auch andere elektronische Bauteile im Betrieb erhebliche Wärme entwickeln können, werden diese Bauteile bevorzugt auf gut wärmeleitenden Leiterplatten, wie beispielsweise Metallkernplatinen, angeordnet, während andere Bauteile auf einfachen Leiterplatten aus Kunststoff angebracht sind. Die Leiterplatten selbst sind dabei häufig aus Platzgründen zumindest teilweise übereinander angeordnet.

Problematisch bei diesen Beleuchtungsvorrichtungen ist jedoch die elektrische Verbindung der Leiterplatten untereinander. Insbesondere bei Metallkernplatinen ist eine Verbindung praktisch nur mittel SMD-Steckverbindern oder durch direktes Anlöten der Kabel möglich, was einen hohen Herstellaufwand bedingt und die Vorhaltung einer Vielzahl von Bauteilen erforderlich macht. Eine derartige Vorrichtung, bei der Platinen mittels Kabeln verbunden wrden, ist in der US 2008/0013334 A1 gezeigt.

Weitere den Stand der Technik beschreibende Dokumente sind DE 10 2007 037839 A1 und US 6 305 949 B1.

### Darstellung der Erfindung

Die Aufgabe der vorliegenden Erfindung ist es daher, eine Beleuchtungsvorrichtung umfassend mindestens eine Lichtquelle, insbesondere mindestens eine Leuchtdiode (LED), sowie mindestens zwei zumindest teilweise übereinander und bevorzugt annähernd parallel angeordnete Leiterplatten sowie ein Verfahren zur Herstellung einer derartigen Beleuchtungsvorrichtung zu schaffen, womit auf einfache Weise eine elektrische Verbindung zwischen den Leiterplatten hergestellt werden kann.

Diese Aufgabe wird bezüglich der Vorrichtung gelöst durch die kennzeichnenden Merkmale des Anspruchs 1 sowie bezüglich des Verfahrens durch die kennzeichnenden Merkmale des Anspruchs 11.

Besonders vorteilhafte Ausgestaltungen finden sich in den abhängigen Ansprüchen.

Indem die mindestens zwei Leiterplatten mittels mindestens eines Steckverbindungselements verbunden sind, wobei das Steckverbindungselement an mindestens einer Seite als Presspassungsstecker ausgebildet ist, wird eine einfache Möglichkeit geschaffen, die Leiterplatten elektrisch leitend miteinander zu verbinden. Der Presspassungsstecker kann ohne Lötverbindung in eine passende Öffnung im Bereich der Leiterplatte eingebracht werden, wodurch auf eine Lötung verzichtet werden kann. Dadurch wird sowohl ein Arbeitsschritt eingespart als auch die Nachteile einer Lötverbindung vermieden. Diese liegen insbesondere in der mangelnden Flexibilität und Lösbarkeit der Verbindung sowie der thermischen Belastung der beteiligten und umliegender Komponenten. Geringe Maßtoleranzen bei der Positionierung der Leiterplatten zueinander können durch die übliche Formgebung des Presspassungssteckers kompensiert werden. Zudem ermöglicht die Erfindung eine kompakte Bauweise, da die Steckverbindungselemente nur wenig Platz benötigen und beispielsweise auf aufwändige Stecker oder Kabelverbindungen verzichtet werden kann.

Indem mindestens eine erste Leiterplatte der mindestens zwei Leiterplatten mindestens einen sich über wesentliche Flächen der Leiterplatte ausdehnenden elektrisch leitenden Bereich aufweist, insbesondere, dass mindestens die erste Leiterplatte als Metallkernplatine ausgebildet ist, kann diese Leiterplatte besonders gut zur Ableitung von Wärme aber auch zur verteilung elektrischer Energie bzw. zu einer großflächigen Kontaktierung verwendet werden.

Es ist vorteilhaft, wenn das Steckverbindungselement auf der dem Presspassungsstecker abgewandten Seite zumindest abschnittsweise eine elektrisch isolierende Umhüllung aufweist, insbesondere praktisch allseitig von der elektrisch isolierenden Umhüllung umgeben ist. Dadurch kann diese Seite mit spannungsführenden Teilen in Kontakt kommen, ohne dass ein elektrischer Kontakt zu diesen hergestellt wird. Die ist insbesondere von Vorteil, wenn das Steckverbindungselement im Bereich der zweiten Leiterplatte mit mehreren spannungsführenden Bereichen in Kontakt stehen würde, da so definiert der Kontakt zu einem bestimmten Bereich herstellbar ist.

Zweckmäßigerweise weist mindestens eine Leiterplatte mindestens eine Bohrung zur Aufnahme des Steckverbindungselements auf. Dadurch wird ein besonders einfacher Aufbau erzielt, da auf eine spezielle Haltevorrichtung oder eine Buchse zur Aufnahme des Steckverbindungselements verzichtet werden kann.

Vorteilhafterweise ist die mindestens eine Bohrung zur Aufnahme des Presspassungssteckers ausgebildet. Dadurch kann auf eigenständige Buchsen zur Aufnahme des Presspassungssteckers verzichtet werden.

Indem die zur Aufnahme des Presspassungssteckers ausgebildete Bohrung zumindest teilweise elektrisch leitende Abschnitte aufweist, kann die Kontaktierung zu dem Presspassungsstecker auf einfache Weise vorgenommen werden. Es entfallen separate elektrische Kontakte und mit dem Steckvorgang wird sowohl eine mechanische wie eine elektrische Verbindung hergestellt.

Indem die mindestens eine Bohrung zur Aufnahme der elektrisch isolierenden Umhüllung des Steckverbindungselements ausgebildet ist, ist sichergestellt, dass dieser Teil des Steckverbinders in der aufnehmenden Leiterplatte sicher gehalten wird.

Vorteilhafterweise weist das Steckverbindungselement an der dem Presspassungsstecker abgewandten Seite mindestens einen Lötanschluss auf. Damit kann die dem Presspassungstecker abgewandte Seite auf einfachem Wege mit der zugehörigen Leiterplatte verbunden werden.

Es ist von Vorteil, wenn die das Steckverbindungselement auf der dem Presspassungsstecker abgewandten Seite zumindest abschnittsweise umgebende elektrisch isolierende Umhüllung auf der dem Pressspannungsstecker abgewandten Seite einen anderen Querschnitt aufweist als auf der dem Presspassungsstecker zugewandten Seite. Dadurch kann beispielsweise ein Durchrutschen des Steckverbindungslements durch die Leiterplatte in einer Richtung verhindert und so die Bestückung der selbigen erleichtert werden. Auch kann auf diese Weise verhindert werden dass das Steckverbindungselement von der falschen Seite eingeführt wird.

Ist der Querschnitt der elektrisch isolierenden Umhüllung auf der dem Presspassungsstecker abgewandten Seite größer als auf der dem Presspassungsstecker zugewandten Seite, wird ein zu weites Einstecken des Steckverbindungselements in die die elektrisch isolierende Umhüllung aufnehmende Leiterpatte vermieden.

Ist der Querschnitt der elektrisch isolierenden Umhüllung auf der dem Presspassungsstecker zugewandten Seite größer als auf der dem Presspassungsstecker abgewandten Seite, wird verhindert, dass das Steckelement beim Einführen des Presspassungssteckers in die zu dessen Aufnahme bestimmte Leiterplatte nach oben durch die zur Aufnahme der elektrisch isolierenden Umhüllung vorgesehenen Leiterplatte gedrückt wird.

Indem die elektrisch isolierende Umhüllung zumindest abschnittsweise eine nicht rotationssymmetrische Querschnittsfläche aufweist, kann auf vorteilhafte Weise ein Verdrehschutz für das Steckverbindungselement verwirklicht werden. Dies ist insbesondere dann wirkungsvoll, wenn auf der Leiterplatte, die die elektrisch isolierende Umhüllung aufnimmt, durch die Formgebung zumindest eines Abschnitts der Bohrung und/oder eines Bauteils nahe der Bohrung eine Fixierung des Steckverbindungselements in Rotationsrichtung erzielt wird. Aber auch ohne ein passgenaues Gegenstück im Bereich der Leiterplatte kann eine nicht rotationssymmetrische Querschnittsfläche hilfreich sein, um die Orientierung des Steckverbindungselements zu erkennen und gegebenenfalls zu korrigieren.

In einer Weiterbildung der Erfindung ist es zweckmäßig, wenn die Beleuchtungsvorrichtung mindestens einen Sockel aufweist und mindestens eine Leiterplatte mechanisch und elektrisch mit dem Sockel verbunden ist. Derartige Beleuchtungsvorrichtungen sind zumeist als so genannte Retrofit-Lösungen dazu gedacht, herkömmliche Lampen zu ersetzten und daher in ihrer räumlichen Ausdehnung sehr begrenzt und in der Form festgelegt, so dass es besonders wichtig ist, die beiden Leiterpatten auf eine besonders einfache und platzsparende weise zu verbinden.

Vorteilhafterweise kann eine erfindungsgemäße Beleuchtungsvorrichtung mit einem Verfahren gefertigt werden, bei dem in einem ersten Schritt das Steckverbindungselement mit dem dem Presspassstecker abgewandten Teil in eine erste Leiterplatte eingeführt wird und in einem zweiten Schritt der Presspassungsstecker in eine Bohrung in einer zweiten Leiterplatte eingeführt wird. Dies stellt eine besonders einfache Fertigungsmethode dar, da die Einführung des dem Presspassstecker abgewandten Teils eine genaue Positionierung des Steckverbindungselements in der Leiterplatte in Querrichtung zur Steckverbindungslängsachse bei gleichzeitiger Verschiebbarkeit in Längsrichtung ermöglicht, während bei einer Presspassung dies nicht so ohne weiteres möglich ist, da insbesondere ein Verschieben des Presspassungssteckers, nachdem einmal die Presspassung hergestellt ist, nur unter großem Aufwand und mit der Gefahr der Zerstörung der Leiterplatte möglich ist.

Es ist weiterhin von Vorteil, wenn vorzugsweise zwischen zweiten und dem dritten Schritt der dem Presspassstecker abgewandte Teil mit der ersten Leiterplatte vorzugsweise mittels eines Lötprozesses, insbesondere mittels Reflow-Löten, elektrisch verbunden wird. Zu diesem Zeitpunkt sind die beiden Leiterplatten noch voneinander getrennt, weshalb die Lötung einfach vorgenommen werden kann.

Weiterhin ist es von Vorteil, wenn das Steckverbindungselement beim Einführen des Presspassungssteckers in die zweite Leiterplatte auf der dem Presspassungsstecker abgewandten Seite mittels eines Stempels fixiert wird Dadurch wird ein Herausrutschen des Steckverbindungselements aus der ersten Leiterplatte zuverlässig vermieden ohne dass eine aufwändige mechanische Befestigung zur Fixierung des Steckverbindungselements in der ersten Leiterplatte nötig wird.

### Kurze Beschreibung der Zeichnungen

Im Folgenden soll die Erfindung anhand von Ausführungsbeispielen näher erläutert werden. Die Figuren zeigen:
- Fig. 1: ein Steckverbindungselement für eine erfindungsgemäße Beleuchtungsvorrichtung,
- Fig. 2: eine erste erfindungsgemäße Beleuchtungsvorrichtung,
- Fig. 3: eine weitere Ausführungsform eines Steckverbindungselements in einer erfindungsgemäßen Beleuchtungsvorrichtung,
- Fig. 4: zwei weitere Ausführungsformen einer erfindungsgemäßen Beleuchtungsvorrichtung.

### Bevorzugte Ausführung der Erfindung

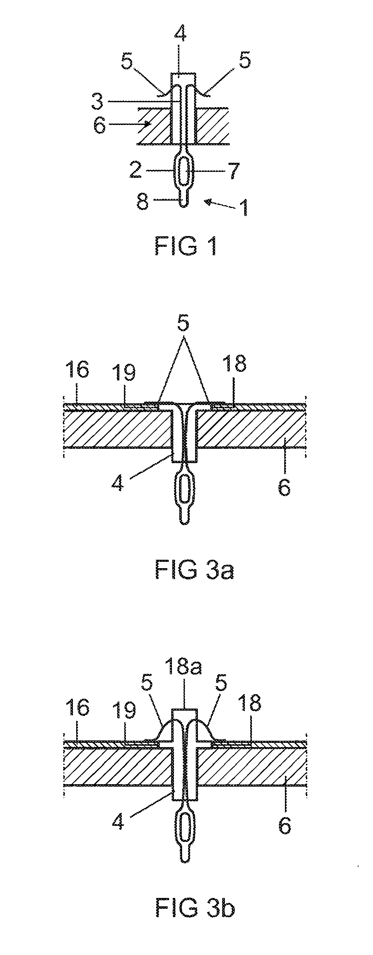

Figur 1 zeigt ein erfindungsgemäßes Steckverbindungselement 1 mit einem Presspassungsstecker 2 und einem stiftförmigen, von dem Presspassungsstecker 2 abgewandten Teil 3, der allseitig mit einer elektrisch isolierenden Umhüllung 4 umgeben ist. Als Isoliermaterial zur Umhüllung des Steckverbindungselements wird der Polyamidwerkstoff PA 6 verwendet, dem Fachmann sind aber in Abhängigkeit von den Anforderungen auch andere Werkstoffe geläufig.

Am von Presspassungsstecker 2 abgewandten Teil 3 sind zwei Anschlussdrähte 5 befestigt, die als Lötanschluss zur elektrischen Kontaktierung des Steckverbindungselements 1 mit einer ersten Leiterplatte 6 dienen. Das zylindrische Steckverbindungselement 1 ist im Bereich des Presspassungssteckers 2 abgeflacht, d.h. der Querschnitt verengt sich in einer Richtung und weitet sich in einer orthogonal dazu verlaufenden Richtung auf. In diesem abgeflachten Teil befindet sich eine Öffnung 7. An der Spitze läuft der Presspassungsstecker 2 wieder in einem zylindrischen Teil 8 aus, der vorne abgerundet ist.

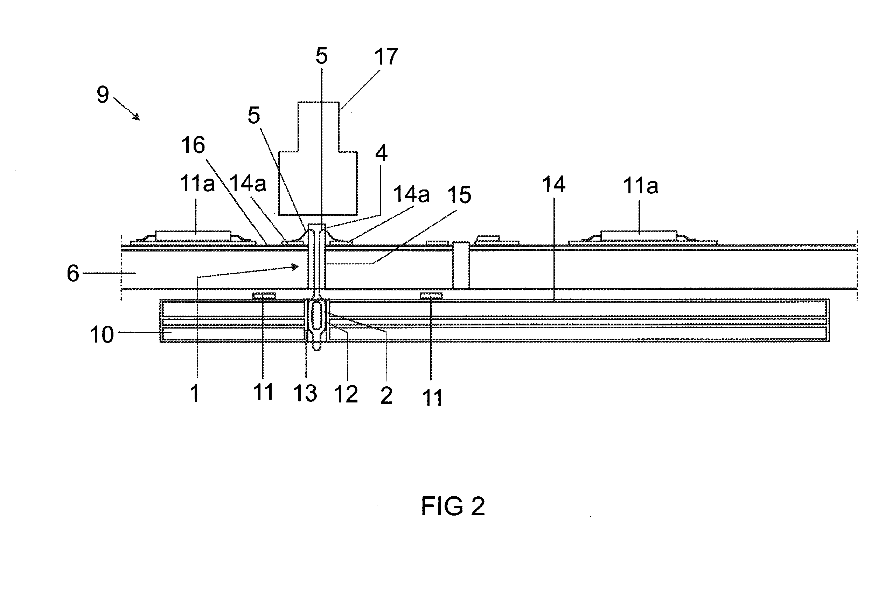

Das Steckerbindungselement 1 wird in einer erfindungsgemäßen Beleuchtungsvorrichtung 9 durch ein erfindungsgemäßes Verfahren eingebracht, was anhand von Figur 2 verdeutlicht wird.

In dem in Figur 2 gezeigten Ausführungsbeispiel umfasst die Beleuchtungsvorrichtung 9 im Wesentlichen eine erste Leiterplatte 6, die als Metallkernplatine 6 ausgeführt ist, eine zweite Leiterplatte 10, die als herkömmliche Leiterplatte 10, beispielsweise vom Typ FR4, ausgeführt ist. Beide Leiterplatten 6, 10 sind mit elektronischen Komponenten 11, 11a bestückt, wobei auf der Metallkernplatine 10 aufgrund der besseren Wärmeleitung die Leuchtdioden 11a der Beleuchtungsvorrichtung 9 angebracht sind. Die Bauelemente 11, 11a sind als SMD-Bauteile ausgeführt.

Die zweite, herkömmliche Leiterpatte 10 ist mit einer Bohrung 12 zur Aufnahme des Presspassungssteckers 2 versehen, die mit einem elektrisch leitfähigen Werkstoff 13 ausgekleidet ist. Dieser Werkstoff 13 ist zumeist identisch mit dem für die Leiterbahnen 14 verwendeten Werkstoff, also vorzugsweise Kupfer beziehungsweise eine Legierung auf Kupferbasis, und steht mit zumindest einer Leiterbahn 14 in elektrischer Verbindung. Bevorzugt wird die Auskleidung 13 zusammen mit den Leiterbahnen 14 aufgebracht.

Auf der dem Presspassungsstecker 2 angewandten Seite ist das Steckverbindungselement 1 mit der elektrisch isolierenden Umhüllung 4 in einer Bohrung 15 gehalten und mittels der Anschlussdrähte 5 mit Leiterbahnen 14a elektrisch verbunden, die wiederum auf einer elektrisch isolierenden Schicht 16 angeordnet sind.

Bei der Fertigung der Beleuchtungsvorrichtung 9 wird zunächst das Steckverbindungselement 1 in die Bohrung 15 eingebracht und die Anschlussdrähte 5 beispielsweise mittels eines Reflow-Lötvorgangs mit den Leiterbahnen 14a verbunden. Dazu sind die Leiterbahnen 14a mit einer Oberflächenbehandlung nach dem Stand der Technik, beispielsweise einer Chemisch-Zinn-Beschichtung, vorbereitet.

Im Rahmen des Lötvorgangs können auch die übrigen Bauteile 11a verlötet werden. Anschließend werden die beiden Leiterplatten 6, 10 in eine passende Position gebracht und soweit aneinander herangeführt, dass der Presspassungsstecker 2 in die Bohrung 12 eingeführt wird. Dabei wird mittels eines Stempels 17 verhindert, dass das Steckverbindungselement 1 nach oben aus der ersten Leiterplatte 6 herausgedrückt und die Anschlussdrähte 5 abgerissen werden. Anschließend werden die Leiterplatten 6, 10 mittels hier nicht dargestellter Befestigungen mechanisch fixiert.

Zwei weitere Ausführungsformen eines erfindungsgemäßen Steckverbindungselements 1 sind in Figur 3 in eingebautem Zustand gezeigt. Bei beiden Ausführungsformen weist die isolierende Umhüllung einen Bereich 18 mit vergrößertem Querschnitt auf, so dass ein Durchrutschen des Steckerbindungselements 1 durch die Leiterplatte 6 verhindert wird.

Bei der Ausführungsform nach Figur 3a ist die isolierende Schicht 18 im eingebauten Zustand annähernd plan in der isolierenden Schicht 16 angeordnet, wodurch die Anschlussdrähte 5 flach zur Seite weggeführt werden können. Dies ermöglicht es, den Stempel 17 bei der Herstellung der Beleuchtungsvorrichtung plan auf der Leiterplatte 6 aufzusetzen, was die korrekte Positionierung des Steckverbindungselements 1 in Relation zur Leiterplatte 6 erleichtert. Zudem ragt das Steckverbindungselement 1 bei der gezeigten Bauweise nicht wesentlich über die Leiterplatte 6 hinaus, was beispielsweise das Anbringen von weiteren Bauelementen wie Reflektoren oder Optiken auf der Leiterplatte 6 erleichtert und den Strahlengang des von den Leuchtdioden 11a ausgehenden Lichts nicht stört. Der Bereich 18 ist zudem nicht rotationssymmetrisch ausgebildet. Durch eine passende Formgebung der Ausnehmung 19 in der isolierenden Schicht 16 der Leiterplatte 6 kann so ein Verdrehschutz realisiert werden. Die genaue Formgebung der Ausnehmung 19 wie des Bereichs 18 ist dabei von den Anforderungen an die Verdrehsicherheit gegeben, denkbar sind beispielsweise dreieckige, rechteckige, sternförmige, elliptische oder vollkommen unregelmäßig geformte Querschnitte, wobei sich die Querschnitte der Ausnehmung 19 und des Bereichs 18 auch unterscheiden können, also beispielsweise eine quadratischer Bereich 18 in einer rechteckförmigen Ausnehmung 19.

In Figur 3b ist die isolierende Umhüllung ist jedoch in einem Bereich 18a nach oben verlängert, so dass die Anschlussdrähte 5 zur Seite weggeführt werden können und vor Beschädigung beim Aufsetzten des Stempels 18 geschützt sind.

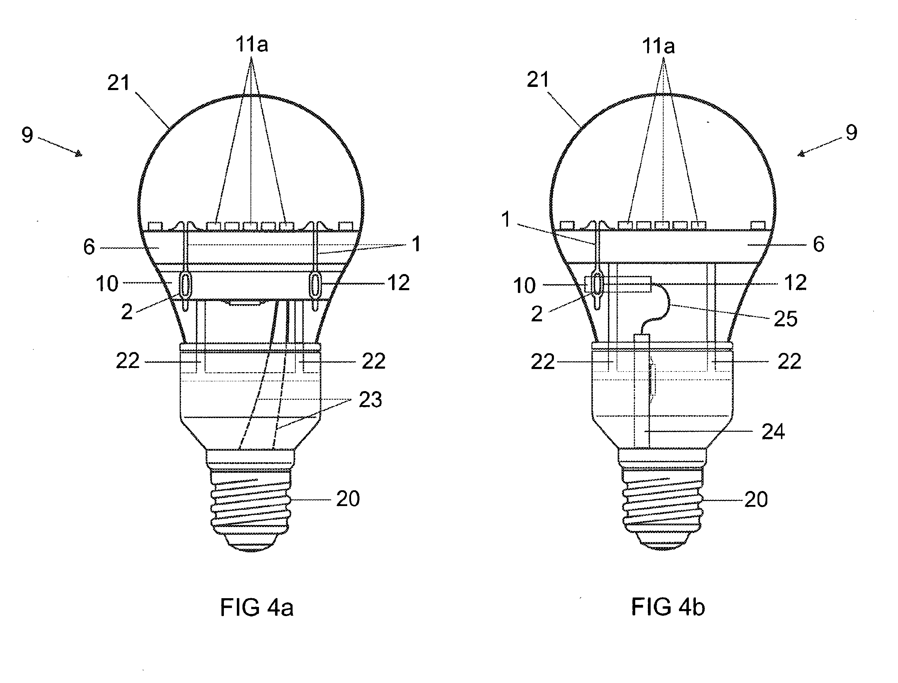

Figur 4 zeigt zwei verschiedene Ausführungen einer erfindungsgemäßen Beleuchtungsvorrichtung 9, wobei es sich jeweils um so genannte Retrofit-LED-Lampen 9 handelt, die als Ersatz für herkömmliche Glühlampen verwendet werden können. Die Beleuchtungsvorrichtung 9 umfasst neben den beiden Leiterplatten 6, 10 mit den Leuchtdioden 11a und den Steckverbindungslementen 1 noch einen Sockel 20 sowie einen Kolben 21, der sowohl die in seinem Inneren enthaltenen Bauelemente 6, 10, 11, 11a vor Beschädigung und Umwelteinflüssen schützt und ein Berühren von spannungsführenden Bauteilen verhindert als auch dem Benutzer den Anblick einer herkömmlichen Glühlampe bietet.

Zur Halterung der Leiterplatten 6, 10 sind mechanische Befestigungselemente 22 vorgesehen, während die elektrische Verbindung erfindungsgemäß mittels der Steckverbindungselemente 1 erfolgt. Die Montage der Beleuchtungsvorrichtung 9 erfolgt damit vorteilhafterweise so, dass zunächst die herkömmliche Leiterplatte 10 mit dem Sockel 20 verbunden wird, wobei dies entweder, wie in Figur 4a gezeigt, mittels einer Kabelverbindung 23 erfolgt, oder aber, wie in Figur 4b gezeigt, mittels einer weiteren herkömmlichen Leiterplatte 24, die mit der herkömmlichen Leiterplatte 10 über eine bei derartigen Leiterplatten 10, 24 übliche Verbindung, beispielsweise mittels herkömmlicher Steckverbinder und Flachbandkabel, erfolgen kann. Die herkömmliche Leiterplatte 10 dient in diesem Ausführungsbeispiel vorwiegend dazu, den Kontakt zu der Metallkernplatine 6 mittels des Steckverbindungselements 1 herzustellen.

Anschließend wird die mit Steckverbindungselementen 1 bestückte Metallkernplatine 6, wie oben geschildert, oberhalb der herkömmlichen Leiterplatte 10 positioniert und die Presspassungsstecker 2 in die Bohrungen 12 der herkömmlichen Leiterplatte 10 eingeführt. Gleichzeitig wird über die mechanischen Verbindungselemente 22 die Metallkernplatine 6 fixiert.

Selbstverständlich sind anstelle der gezeigten Ausführungsbeispiele auch andere Ausführungsformen der Erfindung denkbar. So kann beispielsweise die Beleuchtungsvorrichtung 9 zusätzlich zu den in den Ausführungsbeispielen gezeigten Komponenten noch weitere Bauteile wie optische Elemente, Kühlkörper oder Gehäuse, umfassen. Auch kann die Ausführung des Steckverbindungselements 1 sich von den gezeigten Varianten unterscheiden, indem beispielsweise das Steckverbindungselement beidseitig Presspassungsstecker 2 aufweist.

Es ist ebenfalls denkbar, dass die Umhüllung auf der dem Presspassungsstecker 2 zugewandten Seite einen größeren Querschnitt aufweist als auf der davon abgewandten Seite. Neben der in den Ausführungsbeispielen gezeigten Variante mit dem abgesetzten Teil der Umhüllung 4 kann diese auch kontinuierlich in ihrem Querschnitt variieren und so beispielsweise konisch oder pyramidenförmig ausgebildet sein. Auch der Querschnitt des Steckverbindungselements 1 ist nicht notwendigerweise rund sondern kann beliebige andere Formen, insbesondere quadratische oder sechseckige Form, annehmen.

Für die Gestaltung des Presspassungssteckers 2 sind dem Fachmann ebenfalls unterschiedliche Formen bekannt, wobei der Stecker nicht notwendigerweise eine Öffnung 7 enthalten muss. Zudem kann die zur Aufnahme des Presspassungssteckers 2 vorgesehene Bohrung 12 in ihrer Formgebung wie auch der Form der Auskleidung an besondere Erfordernisse angepasst werden. Die gängigen Möglichkeiten liegen im Wissen des Fachmanns.

Auch kann die Anordnung der beiden Leiterplatten 6, 10 zueinander wie auch die Art der Leiterplatten 6, 10 selbst selbstverständlich von den gezeigten Ausführungsbeispielen abweichen. Insbesondere ist eine vollständige Überlappung zwischen den Leiterplatten 6, 10, wie auch in Figur 4 auf der rechten Seite gezeigt, nicht notwendig.

Zudem können leichte Abweichungen von der Parallelität durch geeignete Neigung der Bohrungen 12, 15 in den Leiterplatten 6, 10 ausgeglichen werden.

Auch für die Oberflächenbehandlung der Leiterplatten 6, 10 und der darauf angeordneten Leiterbahnen 14, 14a sind eine Vielzahl von Verfahren bekannt, ebenso wie für die Möglichkeit, die Bauteile 11, 11a auf den Leiterplatten 14, 14a anzubringen und zu kontaktieren. Dies gilt auch für die Kontaktierung des dem Presspassungssteckers 2 abgewandten Teils 3 des Steckverbindungselements 1.

## Patentansprüche

1. Beleuchtungsvorrichtung (9) umfassend mindestens eine Lichtquelle, insbesondere mindestens eine Leuchtdiode (LED) (lla), sowie mindestens zwei zumindest teilweise übereinander und bevorzugt annähernd parallel angeordnete Leiterplatten (6,10), wobei mindestens eine erste Leiterplatte (6) als Metallkernplatine (6) ausgebildet ist, wobei mindestens diese erste Leiterplatte (6 ) mindestens eine Bohrung (15) aufweist **dadurch gekennzeichnet, dass** die mindestens zwei Leiterplatten (6, 10) mittels mindestens eines Steckverbindungselements (1) verbunden sind, wobei das Steckverbindungselement (1) an mindestens einer Seite als Presspassungsstecker (2) ausgebildet ist und das Steckverbindungselement (1) auf der dem Presspassungsstecker (2) abgewandten Seite (3) zumindest abschnittsweise eine elektrisch isolierende Umhüllung (4) aufweist, insbesondere praktisch allseitig von der elektrisch isolierenden Umhüllung (4) umgeben ist, und die mindestens eine Bohrung (15) zur Aufnahme der elektrisch isolierenden Umhüllung (4) des Steckverbindungselements (1) ausgebildet ist.

2. Beleuchtungsvorrichtung (9) nach Anspruch 1, **dadurch gekennzeichnet, dass** mindestens eine Bohrung (12) zur Aufnahme des Presspassungssteckers (2) ausgebildet ist.

3. Beleuchtungsvorrichtung (9) nach einem der Ansprüche 1 oder 2, **dadurch gekennzeichnet, dass** die zur Aufnahme des Presspassungssteckers (2) ausgebildete Bohrung (12) zumindest teilweise elektrisch leitende Abschnitte (13) aufweist.

4. Beleuchtungsvorrichtung (9) nach einem der Ansprüche 1 bis 3, **dadurch gekennzeichnet, dass** das Steckverbindungselement (1) an der dem Presspassungsstecker (2) abgewandten Seite (3) mindestens einen Lötanschluss (5) aufweist.

5. Beleuchtungsvorrichtung (9) nach einem der Ansprüche 1 bis 4, **dadurch gekennzeichnet, dass** die das Steckverbindungselement (1) auf der dem Presspassungsstecker (2) abgewandten Seite (3) zumindest abschnittsweise umgebende elektrisch isolierende Umhüllung (4) auf der dem Pressspannungsstecker (2) abgewandten Seite einen anderen Querschnitt aufweist als auf der dem Presspassungsstecker (2) zugewandten Seite.

6. Beleuchtungsvorrichtung (9) nach einem der Ansprüche 1 bis 5, **dadurch gekennzeichnet, dass** die elektrisch isolierende Umhüllung (4) zumindest abschnittsweise eine nicht rotationssymmetrische Querschnittsfläche aufweist.

7. Beleuchtungsvorrichtung (9) nach einem der Ansprüche 1 bis 6, **dadurch gekennzeichnet, dass** die Beleuchtungsvorrichtung (9) mindestens einen Sockel (20) aufweist und mindestens eine Leiterplatte (6, 10) mechanisch und elektrisch mit dem Sockel (20) verbunden ist.

8. Verfahren zur Herstellung einer Beleuchtungsvorrichtung (9) nach einem der Ansprüche 1 bis 7, **dadurch gekennzeichnet, dass** in einem ersten Schritt das Steckverbindungselement (1) mit dem dem Presspassstecker (2) abgewandten Teil (3) in eine erste Leiterplatte (6) eingeführt wird und in einem zweiten Schritt der Presspassungsstecker (2) in eine Bohrung (12) in einer zweiten Leiterplatte (10) eingeführt wird.

9. Verfahren nach Anspruch 8, **dadurch gekennzeichnet, dass** vorzugsweise zwischen zweiten und dem dritten Schritt der dem Presspassstecker (2) abgewandte Teil (3) des Steckverbindungselements (1) mit der ersten Leiterplatte (6) vorzugsweise mittels eines Lötprozesses, insbesondere mittels Reflow-Löten, elektrisch verbunden wird.

10. Verfahren nach Anspruch 8 oder 9, **dadurch gekennzeichnet, dass** das Steckverbindungselement (1) beim Einführen des Presspassungssteckers (2) in die zweite Leiterplatte (10) auf der dem Presspassungsstecker (2) abgewandten Seite (3) mittel eines Stempels (17) fixiert wird.

## Claims

1. Lighting device (9) comprising at least one light source, in particular at least one light-emitting diode (LED) (11a), and at least two printed circuit boards (6, 10), which are arranged at least partially one above the other and preferably approximately parallel to one another, wherein at least one first printed circuit board (6) is in the form of a metal-core printed circuit board (6), wherein at least this first printed circuit board (6) has at least one bore (15), **characterized in that** the at least two printed circuit boards (6, 10) are connected by means of at least one plug-type connection element (1), wherein the plug-type connection element (1) is formed on at least one side as a press-fit plug (2), and the plug-type connection element (1) has, at least sectionally on the side (3) remote from the press-fit plug (2), an electrically insulating sheath (4), in particular is surrounded by the electrically insulating sheath (4) on virtually all sides, and the at least one bore (15) is designed to accommodate the electrically insulating sheath (4) of the plug-type connection element (1).

2. Lighting device (9) according to Claim 1, **characterized in that** at least one bore (12) is designed to accommodate the press-fit plug (2).

3. Lighting device (9) according to either of Claims 1 and 2, **characterized in that** the bore (12) designed to accommodate the press-fit plug (2) has at least partially electrically conductive sections (13).

4. Lighting device (9) according to one of Claims 1 to 3, **characterized in that** the plug-type connection element (1) has, on the side (3) remote from the press-fit plug (2), at least one soldered connection (5).

5. Lighting device (9) according to one of Claims 1 to 4, **characterized in that** the electrically insulating sheath (4) which at least sectionally surrounds the plug-type connection element (1) on the side (3) remote from the press-fit plug (2) has a different cross section on the side remote from the press-fit plug (2) than on the side facing the press-fit plug (2).

6. Lighting device (9) according to one of Claims 1 to 5, **characterized in that** the electrically insulating sheath (4) has, at least sectionally, a non-rotationally symmetrical cross-sectional area.

7. Lighting device (9) according to one of Claims 1 to 6, **characterized in that** the lighting device (9) has at least one base (20) and at least one printed circuit board (6, 10) is mechanically and electrically connected to the base (20).

8. Method for producing a lighting device (9) according to one of Claims 1 to 7, **characterized in that**, in a first step, the plug-type connection element (1) is inserted with the part (3) remote from the press-fit plug (2), into a first printed circuit board (6) and, in a second step, the press-fit plug (2) is inserted into a bore (12) in a second printed circuit board (10).

9. Method according to Claim 8, **characterized in that**, preferably between the second and third step, that part (3) of the plug-type connection element (1) which is remote from the press-fit plug (2) is electrically connected to the first printed circuit board (6), preferably by means of a soldering process, in particular by means of reflow soldering.

10. Method according to Claim 8 or 9, **characterized in that** the plug-type connection element (1), on insertion of the press-fit plug (2) into the second printed circuit board (10), is fixed on the side (3) remote from the press-fit plug (2) by means of a die (17).

## Revendications

1. Dispositif d'éclairage (9) comprenant au moins une source lumineuse, en particulier au moins une diode électroluminescente (DEL) (11a), ainsi qu'au moins deux cartes de circuits (6, 10) au moins partiellement superposées et de préférence sensiblement parallèles, au moins une première carte de circuits (6) étant réalisée sous forme de platine à noyau métallique (6) et au moins cette première carte de circuits (6) comportant au moins un trou de perçage (15), **caractérisé en ce que** lesdites au moins deux cartes de circuits (6, 10) sont reliées par au moins un élément de connexion enfichable (1), l'élément de connexion enfichable (1) étant conformé, au moins d'un côté, en connecteur à ajustage serré (2), et l'élément de connexion enfichable (1), du côté (3) opposé au connecteur à ajustage serré (2), étant pourvu au moins en partie d'une enveloppe électriquement isolante (4), en particulier entouré pratiquement de tous côtés de l'enveloppe électriquement isolante (4), et ledit au moins un trou (15) étant conçu pour recevoir l'enveloppe électriquement isolante (4) de l'élément de connexion enfichable (1).

2. Dispositif d'éclairage (9) selon la revendication 1, **caractérisé en ce qu'**au moins un trou (12) est conçu pour recevoir le connecteur à ajustage serré (2).

3. Dispositif d'éclairage (9) selon l'une des revendications 1 ou 2, **caractérisé en ce que** le trou (12) conçu pour recevoir le connecteur à ajustage serré (2) comporte au moins en partie des portions électroconductrices (13).

4. Dispositif d'éclairage (9) selon l'une des revendications 1 à 3, **caractérisé en ce que** l'élément de connexion enfichable (1) présente du côté (3) opposé au connecteur à ajustage serré (2) au moins une connexion soudée (5).

5. Dispositif d'éclairage (9) selon l'une des revendications 1 à 4, **caractérisé en ce que** l'enveloppe électriquement isolante (4) entourant au moins en partie l'élément de connexion enfichable (1) du côté (3) opposé au connecteur à ajustage serré (2) présente du côté opposé au connecteur à ajustage serré (2) une autre section transversale que du côté tourné vers le connecteur à ajustage serré (2).

6. Dispositif d'éclairage (9) selon l'une des revendications 1 à 5, **caractérisé en ce que** l'enveloppe électriquement isolante (4) présente au moins en partie une surface de section transversale non symétrique en rotation.

7. Dispositif d'éclairage (9) selon l'une des revendications 1 à 6, **caractérisé en ce que** le dispositif d'éclairage (9) possède au moins un culot (20), et au moins une carte de circuits (6, 10) est reliée au culot (20) de manière mécanique et électrique.

8. Procédé de fabrication d'un dispositif d'éclairage (9) selon l'une des revendications 1 à 7, **caractérisé en ce que** dans une première étape, on introduit l'élément de connexion enfichable (1) par le bout (3) opposé au connecteur à ajustage serré (2) dans une première carte de circuits (6) et dans une deuxième étape, on introduit le connecteur à ajustage serré (2) dans un trou (12) percé dans une deuxième carte de circuits (10).

9. Procédé selon la revendication 8, **caractérisé en ce que** de préférence entre la deuxième et la troisième étape, on relie le bout (3) opposé au connecteur à ajustage serré (2) de l'élément de connexion enfichable (1) électriquement à la première carte de circuits (6), de préférence au moyen d'un processus de brasage, en particulier au moyen d'un brasage de type reflow.

10. Procédé selon la revendication 8 ou 9, **caractérisé en ce qu'**en introduisant le connecteur à ajustage serré (2) dans la deuxième carte de circuits (10), on fixe l'élément de connexion enfichable (1) du côté (3) opposé au connecteur à ajustage serré (2) au moyen d'un poinçon (17).
